# EUROPÄISCHE PATENTSCHRIFT

(11) **EP 0 707 712 B1**
(45) Veröffentlichungstag und Bekanntmachung des Hinweises auf die Patenterteilung: **20.11.1996**
(21) Anmeldenummer: 94920877.1
(22) Anmeldetag: 06.07.1994
(51) Int. Cl.: G01R 15/16, G01R 15/06

(54) **VORRICHTUNG ZUR MESSUNG DES POTENTIALS EINES HOCHSPANNUNGSLEITERS**
DEVICE FOR MEASURING THE POTENTIAL OF A HIGH VOLTAGE CONDUCTOR
DISPOSITIF DE MESURE DU POTENTIEL D'UN FIL A HAUTE TENSION

(30) Priorität: 08.07.1993 DE 9310388 U
(43) Veröffentlichungstag der Anmeldung: 24.04.1996
(73) Patentinhaber: SIEMENS AKTIENGESELLSCHAFT, 80333 München (DE); Vogl Electronic GmbH, D-94315 Straubing (DE)
(72) Erfinder: GORABLENKOW, Jörg, D-13591 Berlin (DE); GRUND, Armin, D-13629 Berlin (DE); LÜTHY, Norbert, D-13591 Berlin (DE); PIRCHER, Christian, D-13629 Berlin (DE); VOGL, Franz, D-94315 Straubing (DE)
(74) Vertreter: Fuchs, Franz-Josef, Dr.-Ing.
(86) Internationale Anmeldenummer: DE9400812
(87) Internationale Veröffentlichungsnummer: WO9502195

(56) Entgegenhaltungen:
- EP-A- 0 104 354
- DE-A- 2 758 800
- DE-A- 4 133 936
- FR-A- 2 240 454

## Beschreibung

Die Erfindung bezieht sich auf eine Vorrichtung zur Messung des Potentials eines innerhalb einer Metallkapselung einer Hochspannungsschaltanlage angeordneten Hochspannungsleiters, die eine innerhalb der Metallkapselung von dieser isoliert angeordnete Meßelektrode aufweist.

Eine derartige Vorrichtung ist beispielsweise aus der DE-AS 23 41 073 bekannt. Bei der dort beschriebenen Meßvorrichtung ist eine Elektrode, die Bestandteil des Oberspannungskondensators eines Spannungsteilers ist, derart innerhalb der Metallkapselung befestigt, daß eine hohe dielektrische Festigkeit im Inneren der Metallkapselung gewährleistet ist.

Aus der DE-AS 27 58 800 ist eine Berstscheibe für eine gekapselte Hochspannungsschaltanlage bekannt, die aus einer isoliert, eingebauten mit einer Isolierschicht versehenen Metallplatte besteht, die gleichzeitig als Meßelektrode verwendbar ist.

Der vorliegenden Erfindung liegt die Aufgabe zugrunde, eine Meßvorrichtung der eingangs genannten Art konstruktiv einfach und besonders kostengünstig zu gestalten.

Die Aufgabe wird erfindungsgemäß dadurch gelöst, daß die Meßelektrode durch ein Leiterstück einer Leiterplatte gebildet ist und daß die Vorrichtung in einer Eingußöffnung für einen Gießharzstützer angeordnet ist.

Dadurch, daß die Meßelektrode durch ein, insbesondere, planares Leiterstück einer Leiterplatte gebildet ist, läßt sich Form und Größe der Elektrode durch Ätzen der Leiterplatte in der bekannten Art und Weise, beispielsweise durch chemisches Ätzen einfach und kostengünstig gestalten. Die Leiterplatte läßt sich ohne großen Aufwand innerhalb der Metallkapselung isoliert befestigen.

Bei der Herstellung von Gießharzstützern ist bekanntermaßen eine Eingußöffnung in der den Stützer umgebenden, einen Anschlußflansch bildenden Metallarmatur notwendig. In diese Eingußöffnung kann die Meßelektrode mit geringem Aufwand eingepaßt werden. Der Deckel schließt dann diese Eingußöffnung ab.

Es kann außerdem vorteilhaft vorgesehen sein, daß die Leiterplatte an einem eine Öffnung der Metallkapselung verschließenden Deckel tragend befestigt ist.

Hierdurch ist die Leiterplatte außerhalb der Metallkapselung einfach an dem Deckel montierbar und kann mit dem Deckel zu Wartungszwecken auch leicht wieder entnommen werden. Es kann außerdem ein Anschlußstutzen für den Deckel vorgesehen sein, so daß die Vorrichtung auch platzsparend angeordnet sein kann. Die Leiterplatte kann sich beispielsweise an die Innenkontur des Kapselungsgehäuses der Schaltanlage anpassen. Es ist auch denkbar, daß die Leiterplatte oder wenigstens das Leiterstück für diesen Zweck gekrümmt ausgebildet ist.

Eine weitere vorteilhafte Ausgestaltung der Erfindung sieht vor, daß eine an die Meßelektrode angeschlossene Meßleitung durch den Deckel isoliert durchgeführt und mit einer Steckbuchse an der Außenseite des Deckels leitend verbunden ist. Die Leiterplatte ist zu diesem Zweck durchkontaktiert, d. h., sie weist einen durch sie durchgeführten Leiter auf.

Auf diese Weise steht an der Außenseite des Kapselungsgehäuses der Schaltanlage ein Meßanschluß zur Verfügung, an den eine mit einem Meßgerät verbundene Meßleitung wahlweise einfach anzuschließen ist. Solange hier kein Meßgerät angeschlossen ist, kann die Steckbuchse durch einen Blindstecker abgeschlossen werden.

Im folgenden wird die Erfindung anhand eines Ausführungsbeispiels in einer Zeichnung gezeigt und anschließend beschrieben.

Hierbei zeigt
Figur 1 den Deckel mit einer Meßelektrode in einer Seitenansicht,
Figur 2 den Deckel in einer Draufsicht,
Figur 3 eine innerhalb einer Eingußöffnung für einen Gießharzstützer angeordnete erfindungsgemäße Vorrichtung,

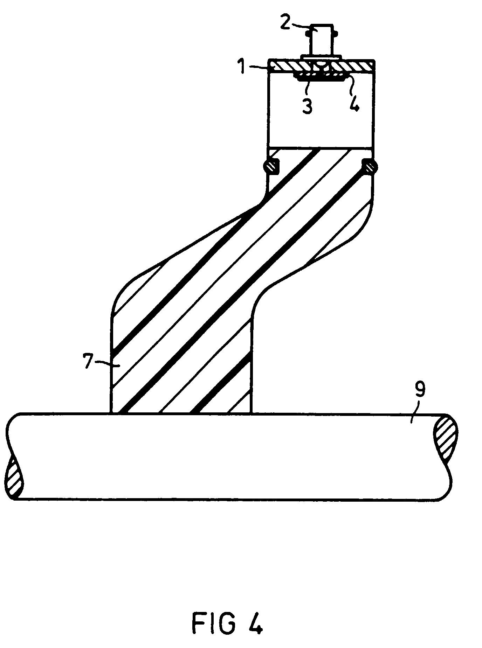

Figur 4 die Vorrichtung aus Figur 3 in einem Teilschnitt.

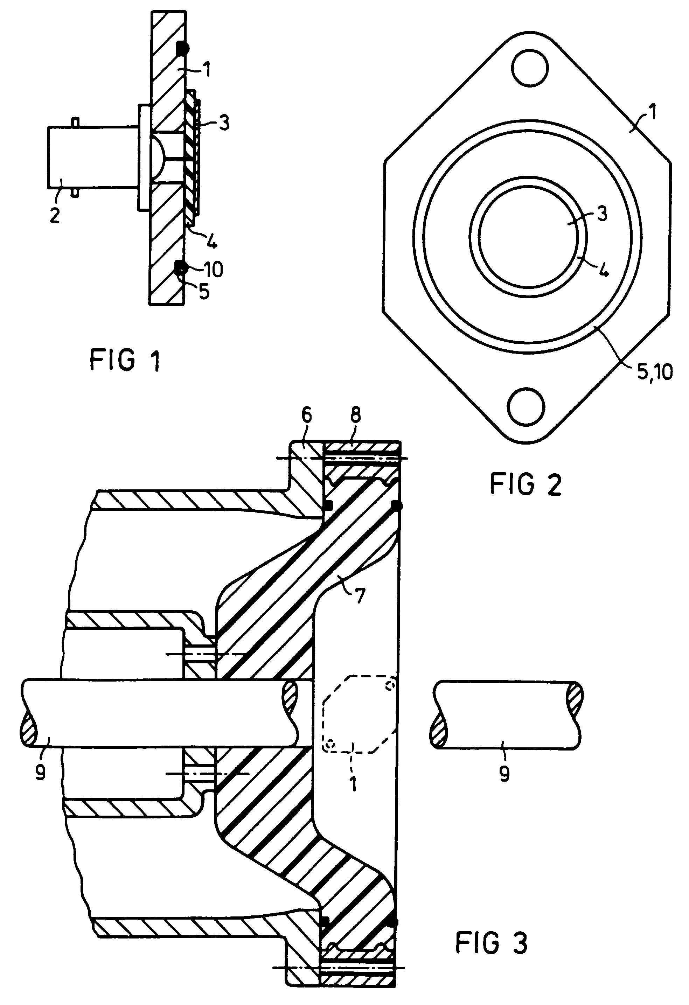

Figur 1 zeigt im Querschnitt den Deckel 1, an dessen Außenseite eine handelsübliche Steckbuchse 2 befestigt ist, die eine Steckverbindung zu der Meßelektrode 3 ermöglicht. Die Meßelektrode 3 ist als leitende Schicht auf einer Leiterplatte 4 ausgebildet, die aus einem isolierenden Kunststoff besteht. Die Leiterplatte 4 ist durchkontaktiert, d. h. von einem Leiter durchsetzt, der mit der Meßelektrode 3 leitend verbunden ist. Der Deckel 1 weist eine Ringnut 5 auf, in der ein Dichtungsring (10) angeordnet ist, der die Dichtung des Deckels (1) gegenüber der Außenwand des Kapselungsgehäuses (6) der Hochspannungsschaltanlage gewährleistet.

In Figur 3 ist ein Gießharzstützer 7 dargestellt, der in einen Metallflansch 8 eingegossen ist. Beim Eingießen in den Metallflansch 8 wird die Gießharzmasse durch eine Öffnung eingebracht, die durch den Deckel 1 verschlossen wird. Dabei ragt die Meßelektrode 3 in den Bereich zwischen dem Metallflansch 8 und dem Gießharzkörper des Gießharzstützers 7 hinein. In der Figur 3 ist der Hochspannungs-Leiter 9, der den Gießharzstützer 7 zentral durchsetzt, der Einfachheit und Übersichtlichkeit halber zum Teil weggelassen.

## Patentansprüche

1. Vorrichtung zur Messung des Potentials eines innerhalb einer Metallkapselung (6, 8) einer Hochspannungsschaltanlage angeordneten Hochspannungsleiters (9), die eine innerhalb der Metallkapselung (6, 8) von dieser isoliert angeordnete Meßelektrode aufweist,
**dadurch gekennzeichnet**, daß
die Meßelektrode (3) durch ein Leiterstück einer Leiterplatte (3, 4) gebildet ist und daß die Vorrichtung (1, 2, 3, 4, 5) in einer Eingußöffnung für einen Gießharzstützer (7) angeordnet ist.

2. Vorrichtung nach Anspruch 1,
**dadurch gekennzeichnet,** daß
die Leiterplatte (4, 3) an einem eine Öffnung der Metallkapselung (6, 8) verschließenden Deckel (1) tragend befestigt ist.

3. Vorrichtung nach Anspruch 1 oder 2,
**dadurch gekennzeichnet**, daß
eine an die Meßelektrode (3) angeschlossene Meßleitung durch den Deckel (1) isoliert durchgeführt und mit einer Steckbuchse (2) an der Außenseite des Deckels (1) leitend verbunden ist.

## Claims

1. Device for measuring the potential of a high-voltage conductor (9) which is arranged inside a metal enclosure (6, 8) of a high-voltage switching installation and has a measuring electrode which is arranged inside the metal enclosure (6, 8) in a manner insulated from the latter, characterized in that the measuring electrode (3) is formed by a conductor element of a printed circuit board (3, 4), and in that the device (1, 2, 3, 4, 5) is arranged in a potting opening for a cast-resin post insulator (7).

2. Device according to Claim 1, characterized in that the printed circuit board (4, 3) is fixed such that it is supported on a cover (1) which closes off an opening of the metal enclosure (6, 8).

3. Device according to Claim 1 or 2, characterized in that a measuring line connected to the measuring electrode (3) is guided through the cover (1) in an insulated manner and is connected in a conductive manner to a socket (2) on the outer side of the cover (1).

## Revendications

1. Dispositif de mesure du potentiel d'un conducteur à haute tension (9) disposé à l'intérieur d'un blindage métallique (6, 8) d'une installation de distribution à haute tension, dispositif qui comporte une électrode de mesure disposée à l'intérieur du blindage métallique (6, 8) de manière à être isolée de ce dernier, caractérisé en ce que l'électrode de mesure (3) est constituée par une pièce conductrice d'une plaquette imprimée (3, 4) et que le dispositif (1, 2, 3, 4, 5) est disposé dans un orifice de coulée destiné à un isolateur support (7) en résine de coulée.

2. Dispositif selon la revendication 1, caractérisé en ce que la plaquette imprimée (4, 3) est fixée, de manière à être portée, sur un couvercle (1) fermant une ouverture du blindage métallique (6, 8).

3. Dispositif selon la revendication 1 ou 2, caractérisé en ce qu'un conducteur de mesure, raccordé à l'électrode de mesure (3), passé, de manière isolée, à travers le couvercle (1) et est relié, de manière conductrice, par une fiche femelle (2), à la face extérieure du couvercle (1).
